(19) Europäisches Patentamt
European Patent Office
Office européen des brevets

(11) **EP 1 443 656 B1**

(12) **EUROPEAN PATENT SPECIFICATION**

(45) Date of publication and mention
of the grant of the patent:
**08.03.2006 Bulletin 2006/10**

(51) Int Cl.:
*H03M 13/00* $^{(2006.01)}$  *G06F 17/16* $^{(2006.01)}$

(21) Application number: **04250320.1**

(22) Date of filing: **22.01.2004**

(54) **Method of generating parity data based on a low-density parity check (LDPC) matrix and apparatus therefor**

Verfahren und Vorrichtung zur Generierung von Prüfdaten basierend auf einer Low-Density Parity Check (LDPC) Matrix

Procédé et appareil de géneration des données de parité basés sur une matrice de code LDPC

(84) Designated Contracting States:
**DE FR GB NL**

(30) Priority: **29.01.2003 KR 2003005927**

(43) Date of publication of application:
**04.08.2004 Bulletin 2004/32**

(73) Proprietor: **SAMSUNG ELECTRONICS CO., LTD.**
**Suwon-si,**
**Gyeonggi-do (KR)**

(72) Inventors:
• **Kim, Ki-Hyun**
**Bundang-gu,**
**Seongnam-si,**
**Gyeonggi-do (KR)**
• **Han, Sung-Hyu**
**Songpa-gu,**
**Seoul (KR)**
• **Park, In-Sik**
**Yeongtong-gu,**
**Suwon-si,**
**Gyeonggi-do (KR)**
• **Lee, Yoon-Woo**
**Suwon-si,**
**Gyeonggi-do (KR)**

(74) Representative: **Robinson, Ian Michael et al**
**Appleyard Lees,**
**15 Clare Road**
**Halifax HX1 2HY (GB)**

(56) References cited:
• **SRIDHAR N ET AL: "Algorithms for the structural diagnosis and decomposition of sparse, underconstrained design systems" COMPUTER AIDED DESIGN, ELSEVIER PUBLISHERS BV., BARKING, GB, vol. 28, no. 4, 1 April 1996 (1996-04-01), pages 237-249, XP004022713 ISSN: 0010-4485**
• **CHEUNG L K ET AL: "The bordered triangular matrix and minimum essential sets of a digraph" IEEE TRANSACTIONS ON CIRCUITS AND SYSTEMS USA, vol. CAS-21, no. 5, September 1974 (1974-09), pages 633-639, XP002300255 ISSN: 0098-4094**
• **TONG ZHANG ET AL: "A class of efficient-encoding generalized low-density parity-check codes" PROC., IEEE INTER. CONFERENCE ON ACOUSTICS, SPEECH, AND SIGNAL PROCESSING, ICASPP'01, vol. 4, 7 May 2001 (2001-05-07), - 11 May 2001 (2001-05-11) pages 2477-2480, XP002300256 ISBN: 0-7803-7041-4**
• **RICHARDSON T J ET AL: "Efficient encoding of low-density parity-check codes" IEEE TRANSACTIONS ON INFORMATION THEORY, IEEE INC. NEW YORK, US, vol. 47, no. 2, February 2001 (2001-02), pages 638-656, XP002965294 ISSN: 0018-9448**

**Description**

The present invention relates to error correction and signal detection, and more particularly to, a method of generating parity data based on low-density parity check matrices and an apparatus therefor.

A coding method based on Low Density Parity Check (LDPC) codes for error correction generates parity check codes which have a predetermined number of 1's in rows and columns of the parity check codes, and then generates parity data based on the parity check codes.

That is, in the coding method based on the LDPC codes, a parity check matrix H having a predetermined number of 1's in its rows and columns is formed, and a codeword x satisfying the equation 'Hx=0' is obtained.

The codeword x is divided into original data and parity data.

In order to obtain the parity data, the parity check matrix H is converted into a generator matrix G by Gaussian elimination, or into a lower triangular form.

In this case, the generator matrix G is not a sparse matrix anymore, thereby increasing the computational time for calculating the codeword x.

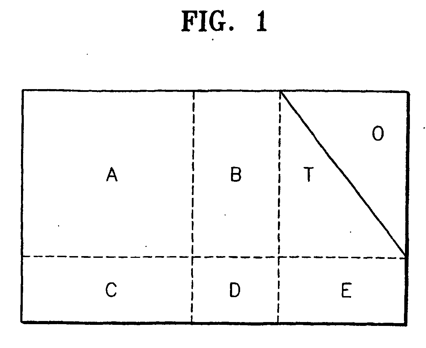

A conventional parity check code matrix H of the form $\begin{bmatrix} A & B & T \\ C & D & E \end{bmatrix}$ is shown in Figure 1.

In order to obtain the codeword x, such that Hx=0, triangulation of the parity check code matrix H is performed, and then pre-multiplication using Gaussian elimination is carried out as shown in the following equation.

$$\begin{bmatrix} I & 0 \\ -ET^{-1} & I \end{bmatrix}\begin{bmatrix} A & B & T \\ C & D & E \end{bmatrix} = \begin{bmatrix} A & B & T \\ -ET^{-1}A+C & -ET^{-1}B+D & 0 \end{bmatrix} \tag{1}$$

However, above calculation process is highly complex and time consuming.

In addition, the basic concept of the LDPC are described by D.J. Mackay, in "Good Error-Correction Codes Based on Very Sparse Matrices", IEEE Trans. on Information Theory, vol. 45, no. 2, pp.399-431, 1999, and an implementation of the H matrix is presented by T.Richardson and R.Urbanke in "Efficient Encoding of Low-Density Parity-Check Codes", IEEE Trans. on Information Theory, vol. 47, no. 2, pp. 638-656, 2001.

According to the present invention there is provided an apparatus and method as set forth in the appended claims. Preferred features of the invention will be apparent from the dependent claims, and the description which follows.

The present invention provides a method of efficiently generating parity data based on low-density parity check matrices and an apparatus therefor.

In accordance with an aspect of the present invention, there are provided a method of generating parity data based on a parity check matrix H having p codewords of length c, each codeword being divided in a message word of length m and parity data of length p, the method comprising: (a) reordering columns of the parity check matrix H based on elements in each column having values of 1 to generate a reordered parity check matrix H'; (b) determining a cross-point I between a diagonal line L2 of a parity matrix part Mp in the parity check matrix H' and a reordered diagonal line L1 defined by first entry of 1 in each column of the reordered parity check matrix H', and, on the basis of positions of 1's in rows above a horizontal line L3 that passes through the cross-point I to perform column permutations on the reordered parity check matrix H', generating a triangular matrix T; (c) using the triangular matrix T and the message words to obtain the parity data; and (d) using the equation Hx=0, where x is a codeword matrix, to obtain the rest of parity data which is not obtained in step (c).

It is preferable that step (a) comprises, finding first entry of 1 in each column in the parity check matrix H; and reordering the columns from left to right in the order of highest entry of 1 in each column.

It is preferable that step (b) comprises, with regard to an above the horizontal line L3, sequentially exchanging from left to right columns of a message matrix part Mm with columns of the parity matrix part Mp in the reordered parity check matrix H'.

It is preferable that step (c) is performed by a backward-substitution method.

It is preferable that step (d) is performed by a Gaussian elimination method.

In accordance with another aspect of the present invention, there is provided a method of generating parity information based on a parity check matrix H having p codewords of length c, each codeword being divided in a message word of length m and parity data of length p, the method comprising: (a) reordering columns in the parity check matrix H based on elements in each column having values of 1 to obtain a reordered parity check matrix H'; (b) determining a cross-point I between a diagonal line L2 of a parity matrix part Mp that corresponds to parity information part in the parity check matrix H' and a reordered diagonal line L1 defined by first entry of 1 in each column of the reordered parity check matrix H', and, on the basis of positions of 1's in rows above a horizontal line L3 that passes through the cross-point I to perform column permutations on the reordered parity check matrix H', forming a triangular matrix T; and (c) for rows under the horizontal line L3, performing rows and columns permutation based on the positions of 1's in the rows to form an extended triangular matrix T; and (d) using the extended triangular matrix T and the message words to obtain the parity data.

It is preferable that step (c) comprises, (c1) checking whether there is a row under the horizontal line L3, in which a second element from right to left having a value of 1 in the row is on the left of the diagonal line L2 of the parity matrix part Mp in the reordered parity check matrix H'; (c2) if there is the row in (c1), exchanging the row with a top-most row under the horizontal line L3; and (c3) exchanging a first column having 1 in the new exchanged top-most row on the right of the diagonal line L2 with a second column having 1 in the new exchanged top-most row on the nearest left of the diagonal line L2.

It is preferable that steps (c1) through (c3) are repeatedly performed until no more row exists, in which a second element from right to left having a value of 1 in the row is on the left of the diagonal line L2.

It is preferable that step (d) comprises, (d1) generating a part of parity data using the extended triangular matrix and the message words.

It is preferable that step (d1) is performed by backward-substitution calculation.

It is preferable that step (d) comprises, (d2) generating remaining parts of parity data by Gaussian elimination.

In accordance with yet another aspect of the present invention, there is provided an apparatus for generating parity information based on a parity check matrix H having p codewords of length c, each codeword being divided in a message word of length m and parity data of length p, the apparatus comprising: (a) means for reordering columns in the parity check matrix H, based on elements in each column having values of 1 to generate a reordered parity check matrix H'; (b) means for determining a cross-point I between a diagonal line L2 of a parity matrix part Mp in the parity check matrix H' and a reordered diagonal line L1 defined by first entry of 1 in each column of the reordered parity check matrix H', and, on the basis of positions of 1's in rows above a horizontal line L3 that passes through the cross-point I to perform column permutations on the reordered parity check matrix H', for generating a triangular matrix T; and (c) means for using the triangular matrix T and the message words to obtain the parity data; (d) means for using the equation Hx=0, where x is a codeword matrix, to obtain the rest of parity data which is not obtained by (c).

It is preferable that the means for reordering columns comprises, means for finding 1's top position of each column in the parity check matrix H; and means for reordering columns from left to right in the order of highest entry of 1 in each column.

It is preferable that the means for determining a cross-point I and using positions of 1's comprises, means for sequentially exchanging from left to right columns of a message matrix part Mm with columns of the parity matrix part Mp in the reordered parity check matrix H', with regard to an above the horizontal line L3.

It is preferable that the means for using the triangular matrix T and the message words generates parity data by the backward-substitution calculation using the triangular matrix T.

It is preferable that the means for determining a cross-point I and for using positions of 1's generates the parity data by Gaussian elimination.

In accordance with still another aspect of the present invention, there is provided an apparatus for generating parity information based on a parity check matrix H having p codewords of length c, each codeword being divided in a message word of length m and parity data of length p, the apparatus comprising, (a) means for reordering columns in the parity check matrix H, based on elements in each column having values of 1 to generate a reordered parity check matrix H'; (b) means for determining a cross-point I between a diagonal line L2 of a parity matrix part Mp in the parity check matrix H and a reordered diagonal line L1 defined by first entry of 1 in each column of the reordered parity check matrix H', and, on the basis of positions of 1's in rows above a horizontal line L3 that passes through the cross-point I to perform column permutations on the reordered parity check matrix H', for generating a triangular matrix T; and (c) means for performing rows and columns permutation based on the positions of 1's in the rows to form an extended triangular matrix T, for rows under the horizontal line L3; and (d) means for using the extended triangular matrix T and the message words to generate the parity data.

It is preferable that the means for performing rows and columns permutation comprises, (c1) means for checking whether there is a row under the horizontal line L3, in which a second element from right to left having a value of 1 in the row is on the left of the diagonal line L2 of the parity matrix part Mp in the reordered parity check matrix H'; (c2) means for exchanging the row with a top-most row under the horizontal line L3, if there is the row in (c1); and (c3) means for exchanging a first column having 1 in the new exchanged top-most row on the right of the diagonal line L2 with a second column having 1 in the same top-most row on the nearest left of the diagonal line L2.

It is preferable that the means for using the extended triangular matrix T comprises, (d1) means for generating part of parity data by backward substitution calculation using the extended triangular matrix and the message words.

It is preferable that the means for using the extended triangular matrix T comprises, (d2) means for generating remaining parity data by Gaussian elimination.

For a better understanding of the invention, and to show how embodiments of the same may be carried into effect, reference will now be made, by way of example, to the accompanying diagrammatic drawings in which:

Figure 1 shows a conventional structure of an H matrix used to obtain a parity for error correction;

Figure 2 is a block diagram of an embodiment of an apparatus for generating parity data based on low-density parity check matrices, according to the present invention;

Figure 3A through 3C illustrate how the parity check matrix is re-structured by a column permutation unit of Figure 2;

Figure 4A through 4D show parity check matrices H for generating parity data, according to the present invention; and

Figure 5 is a flowchart of a method of generating parity data based on low-density parity check matrices, according to the present invention.

The present invention now will be described more fully with reference to the attached drawings, in which exemplary embodiments of the invention are shown.

This invention may, however, be embodied in many different forms and should not be construed as being limited to the embodiments set forth herein; rather these embodiments are provided so that this disclosure will be thorough and complete, and will fully convey the concept of the invention to those skilled in.the art.

In the present invention, the modification to a parity check matrix is restricted to a column or row permutation.

Even if all columns or rows are exchanged, separate equations can be formed using the parity check matrix, so that the column or row permutation does not affect generation of parity data.

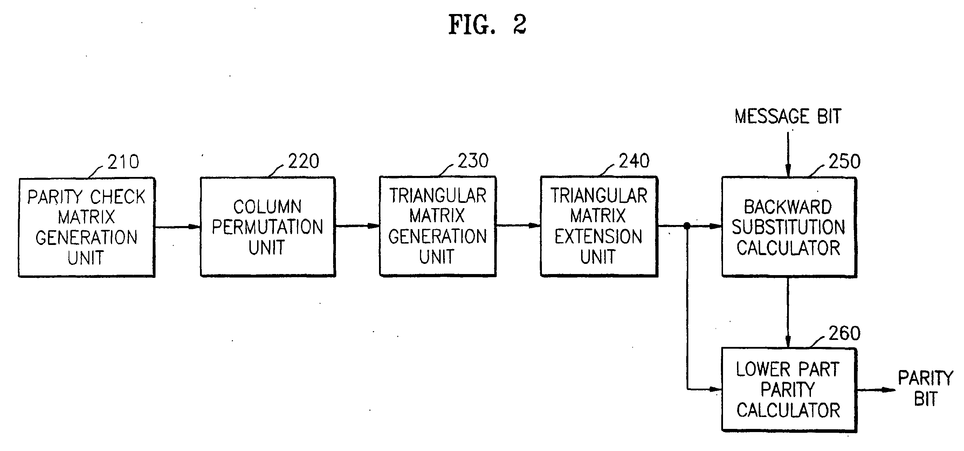

Figure 2 is a block diagram of an embodiment of an apparatus for generating parity data based on low-density parity check matrices.

The apparatus includes a parity check matrix generation unit 210, a column permutation unit 220, a triangular matrix generation unit 230, a triangular matrix extension unit 240, a backward substitution calculator 250, and a lower part parity calculator 260.

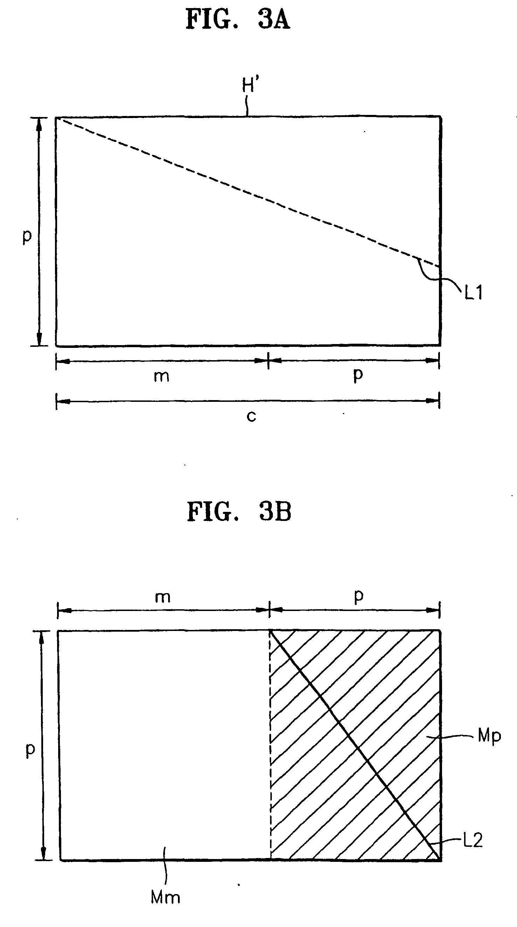

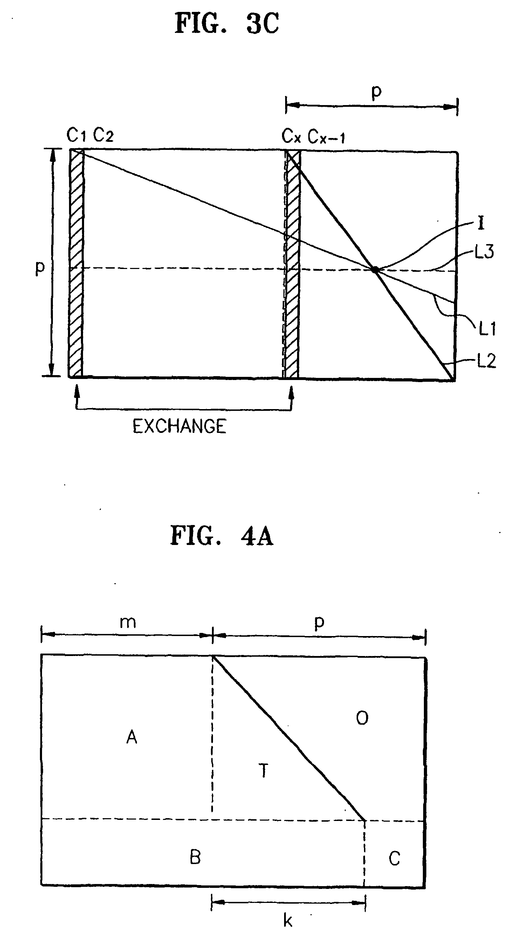

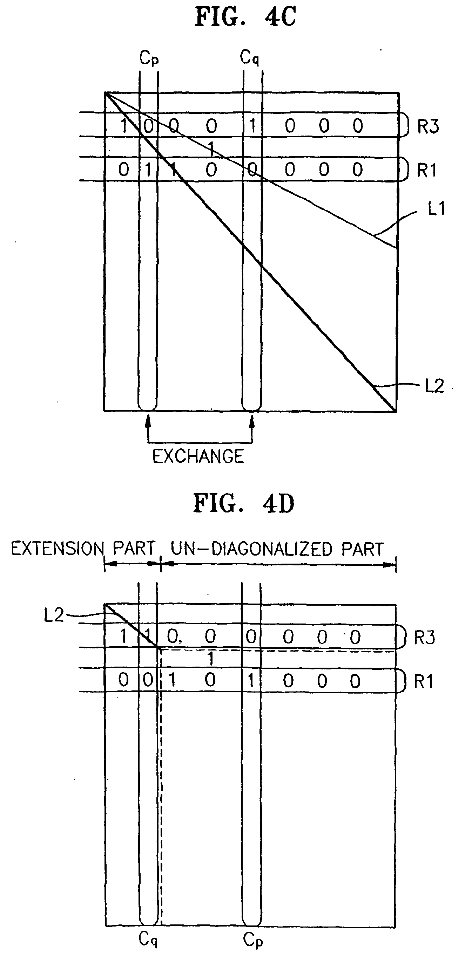

Operations of the apparatus of Figure 2 will now be described with reference to Figures 3A through 3C in conjunction with Figures 4A through 4D.

Referring to Figure 2, the parity check matrix generation unit 210 generates a parity check matrix H with p rows, corresponding to a length of parity data, and c columns, corresponding to a length of a codeword.

Elements of the parity check matrix H are 0's or 1's, and the number of 1's is much less than that of 0's.

The column permutation unit 220 reconstructs the parity check matrix H generated by the parity check matrix generation unit 210 by reordering the columns from left to right such that the upper most values of 1 in each column are arranged, for example, along a diagonal line L1.

In other words, in Figure 3A, column permutation is performed such that columns having higher first entry of 1 are arranged ahead from left to right.

For example, a dotted line L1 in Figure 3A represents a 'reordered diagonal line' which connects the upper-most positions of '1' in the reordered columns.

Figure 3B shows the reordered parity check matrix H'. The reordered parity check matrix H' is divided into a message matrix part Mm having p message words, the length of each message word being m in horizontal direction, and a parity matrix part Mp having p parities, the length of each parity being p in horizontal direction.

A diagonal line L2 in the parity matrix part Mp represents a line that connects diagonal elements in the parity matrix part Mp. Figure 3C shows the column permutation process by triangular matrix generation unit 230.

The triangular matrix generation unit 230 forms a triangular matrix T as shown in Figure 4A, by performing column permutation in the reordered parity check matrix H'.

In Figure 3C, a solid line L1 represents the same reordered diagonal line as in Figure 3A, another solid line L2 represents the same diagonal line of the parity matrix part as in FIG 3B, and an index I represents a cross-point of L1 and L2.

A dotted line L3 is a horizontal line that passes the cross-point I.

In the column permutation process, the first column exchange is performed between the leftmost columns of the message matrix part Mm and the parity matrix part Mp.

That is, columns C1 and Cx are exchanged first, C2 and Cx-1 are exchanged next, and then the similar way of exchange process goes on. The resulting triangular matrix T is shown in Figure 4A.

Figure 4A shows the parity check matrix that includes the triangular matrix T. An upper-right part of the triangular matrix T contains only 0's, an upper part of remaining columns resulted from excluding the permutated k columns from p columns in the parity matrix part Mp with respect to the horizontal line L3 contains 0's, and a lower part of the remaining columns with respect to the horizontal line L3 defines a matrix C of the parity check matrix and includes 0's and 1's.

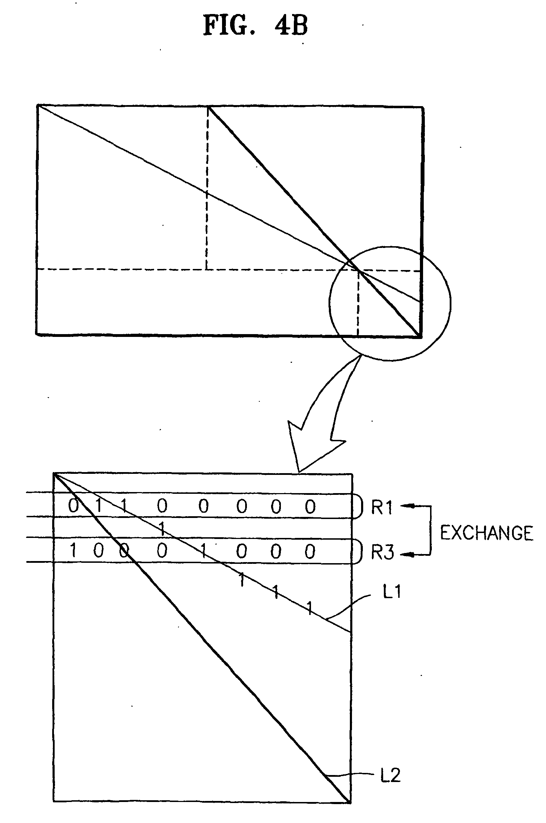

The triangular matrix extension unit 240 sequentially performs a plurality of row permutations and column permutations as shown in FIG 4B and 4C to diagonalize the un-diagonalized matrix C to the maximum possible extent.

Figure 4B and 4C show the row and column permutation processes performed by the triangular matrix extension unit 240.

Referring to Figure 4B, of all the rows under the horizontal line L3, a row in which a second element from right to left of all elements having a value of 1 is on the left of the diagonal line L2 is extracted, e.g., row R3 in Figure 4B, and exchanged with a row R1, the upper-most row under the horizontal line L3. If there is no such a row, e.g., row R3 in Figure 48, which meets the condition that the second 1 from the right end of the matrix is on the left of the diagonal line L2, the triangular matrix extension process performed by the triangular matrix extension unit 240 is finished.

Thereafter, as shown in Figure 4C, a column Cq having a value of '1' in the row R3 on the right of the diagonal line L2, is exchanged with a column Cp having a value of '1' in the row R3 on the left of the diagonal line L2.

If there is no such a column, e.g., column Cp in Figure 4C, no more column permutation is performed, and the triangular extension process is stopped.

As such, the row and column permutations are repeatedly performed until no more row exists in which a second element from right to left having a value of 1 is on the left of the diagonal line L2, and thereby the lower part of the triangular matrix T is extended as much as possible so as to make the matrix C of the parity check matrix as small as possible.

Figure 4D shows a part of the triangular matrix extended by the triangular matrix extension unit 240.

Since a single column has been exchanged in the embodiment shown in Figure 4B and 4C, the triangular matrix T is extended by 1x1 bits in horizontal and vertical directions.

The backward-substitution calculator 250 performs a backward substitution calculation using message bits and the area of the triangular matrix extended by the triangular matrix extension unit 240, thereby obtaining parity bit's values (or parity data). This calculation can be represented by the following equation (2).

$$P_l = -\sum_{j=1}^{n-m} H_{l,j} S_j - \sum_{j=1}^{l-1} H_{l,j+n-m} P_j \qquad (2)$$

From equation (2), k parity bit's values of the whole parity bit's values are obtained.

The lower part parity calculator 260 obtains parity bit's values of the un-diagonalized part, using the Gaussian elimination or the equation (1), since the parity bits excluding k parity bits obtained by the backward-substitution calculator 250 from p parity bits are an excluded part from constructing the triangular matrix T by the triangular matrix extension unit 240, such as matrix C of the parity check matrix shown in Figure 4a, is in a reduced form of the original matrix H.

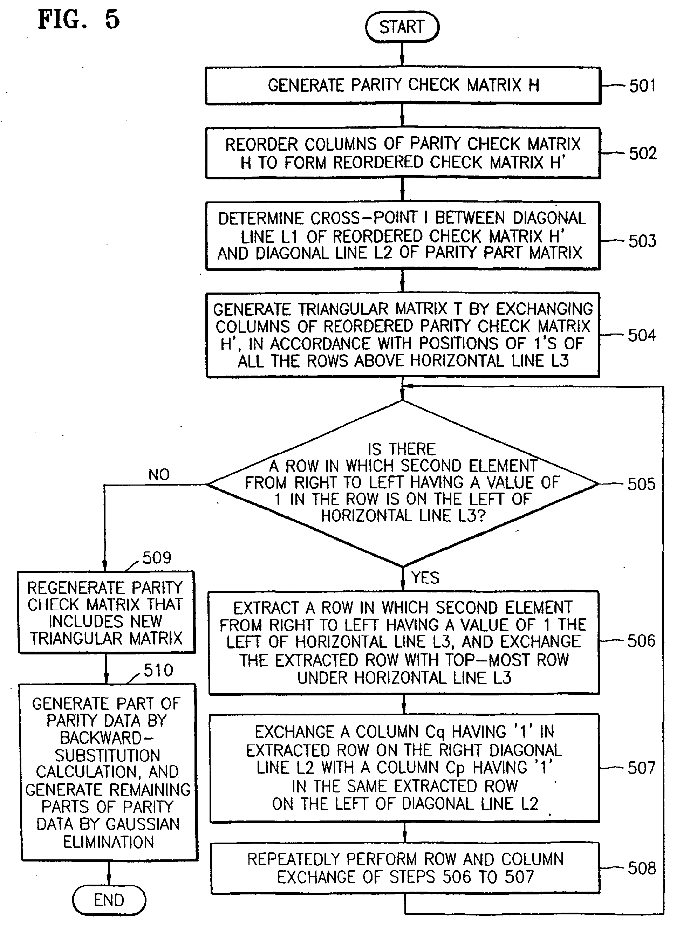

Figure 5 is a flowchart of a method of generating parity data based on the low-density parity check matrix, which will be described in conjunction with Figure 2.

The parity check matrix generation unit 210 generates a c x p parity check matrix H, c being a number of columns and length of a codeword and p being a number of rows and length of a parity in step 501.

The column permutation unit 220 reorders the columns of the matrix H from left to right in the order of highest entry of 1 in each column, resulting in a reordered parity check matrix H' in step 502.

The triangular matrix generation unit 230 determines a cross-point I of the diagonal line L1 of the reordered parity check matrix H' and the diagonal line L2 of the parity matrix part in step 503.

In step 504, a triangular matrix T is generated by exchanging columns of the reordered parity check matrix H', in accordance with the positions of 1's of all the rows above a horizontal line L3 that passes the cross-point I.

At this time, a first column exchange is performed between a left-most column of a message matrix part Mm and a left-most column of a parity matrix part Mp.

That is, referring to Figure 3C, a column C1 of the message matrix part Mm and a column Cx of the parity matrix part Mp are exchanged with one another.

Then, a second most left column C2 of the message matrix part Mm and a second most left column Cx-1 are exchanged with one another, and such column exchanges are sequentially performed on remaining columns in a similar way.

In step 505, it is determined whether a row, under the horizontal line L3, in which a second element from right to left having a value of 1 is on the left of the diagonal line L2.

If such a row exists in step 505, the triangular matrix extension unit 240 performs a plurality of row and column exchanges (permutations), thereby diagonalizing an un-diagonalized matrix C to the maximum extent in step 506 and 507.

In other words, in step 506, of all the rows under the horizontal line L3, a row in which a second most right 1 of all 1's on the row is on the left of the diagonal line L2, is extracted, and then, the extracted row, e.g., R3 of Figure 4B is exchanged with a top-most row e.g., R1 under the line L3.

Thereafter, in step 507, a column Cq on the right of the diagonal line L2, which has a value of '1' corresponding to the extracted row, e.g., R3, is exchanged with a column Cp on the left of the diagonal line L2, which has a value of '0' corresponding to the extracted row, e.g., R3.

In a similar way, row and column permutations are repeatedly performed in step 508.

As such, a parity check matrix including a triangular matrix is regenerated in step 509.

In step 510, the backward-substitution calculator 250 performs a backward-substitution calculation using message bits and the area of the triangular matrix extended by the triangular matrix extension unit 240, thereby obtaining parity data, and the lower part parity calculator 260 obtains parity bit's values (parity data) of an un-diagonalized part according to Gaussian elimination or equation (1).

In such a method according to the present invention, the amounts of computation for generating parity data can be reduced, thereby allowing the parity data to be efficiently obtained.

The present invention can be efficiently applied to technical fields that require fast encoding.

Although a few preferred embodiments have been shown and described, it will be appreciated by those skilled in the art that various changes and modifications might be made without departing from the scope of the invention, as defined in the appended claims.

**Claims**

1. A method of generating parity data based on a parity check matrix H having p codewords of length c, each codeword being divided in a message word of length m and parity data of length p, the method comprising:

    (a) reordering columns of the parity check matrix H based on elements in each column having values of 1 to generate a reordered parity check matrix H';
    (b) determining a cross-point I between a diagonal line L2 of a parity matrix part Mp in the parity check matrix H' and a reordered diagonal line L1 defined by first entry of 1 in each column of the reordered parity check matrix H', the diagonal line L2 representing a line that connects diagonal elements in the parity matrix part Mp and, on the basis of positions of 1's in rows above a horizontal line L3 that passes through the cross-point I to perform column permutations on the reordered parity check matrix H', generating a triangular matrix T;
    (c) using the triangular matrix T and the message words to obtain the parity data; and
    (d) using the equation Hx=0, where x is a codeword matrix, to obtain the rest of parity data which is not obtained in step (c).

2. The method of claim 1, wherein step (a) comprises:

    finding first entry of 1 in each column in the parity check matrix H; and
    reordering the columns from left to right in the order of highest entry of 1 in each column.

3. The method of claim 1 or 2, wherein step (b) comprises:

    sequentially exchanging from left to right columns of a message matrix part Mm with columns of the parity matrix part Mp in the reordered parity check matrix H'.

4. The method of claim 1, 2 or 3, wherein step (c) is performed by a backward-substitution method.

5. The method of claim 1, 2, 3 or 4, wherein step (d) is performed by a Gaussian elimination method.

6. A method of generating parity information based on a parity check matrix H having p codewords of length c, each codeword being divided in a message word of length m and parity data of length p, the method comprising:

    (a) reordering columns in the parity check matrix H based on elements in each column having values of 1 to obtain a reordered parity check matrix H';
    (b) determining a cross-point I between a diagonal line L2 of a parity matrix part Mp that corresponds to parity information part in the parity check matrix H' and a reordered diagonal line L1 defined by first entry of 1 in each column of the reordered parity check matrix H', the diagonal line L2 representing a line that connects diagonal elements in the parity matrix part Mp and, on the basis of positions of 1's in rows above a horizontal line L3 that passes through the cross-point I to perform column permutations on the reordered parity check matrix H',
forming a triangular matrix T; and
(c) for rows under the horizontal line L3, performing rows and columns permutation based on the positions of
1's in the rows to form an extended triangular matrix T; and
(d) using the extended triangular matrix T and the message words to obtain the parity data.

7. The method of claim 6, wherein step (c) comprises:

(c1) checking whether there is a row under the horizontal line L3, in which a second element from right to left
having a value of 1 in the row is on the left of the diagonal line L2 of the parity matrix part Mp in the reordered
parity check matrix H';
(c2) if there is the row in (c1), exchanging the row with a top-most row under the horizontal line L3; and
(c3) exchanging a first column having 1 in the new exchanged top-most row on the right of the diagonal line L2
with a second column having 1 in the new exchanged top-most row on the nearest left of the diagonal line L2.

8. The method of claim 7, wherein steps (c1) through (c3) are repeatedly performed until no more row exists, in which
a second element from right to left having a value of 1 in the row is on the left of the diagonal line L2:

9. The method of claim 6, 7 or 8, wherein step (d) comprises:

(d1) generating a part of parity data using the extended triangular matrix and the message words.

10. The method of claim 9, wherein step (d1) is performed by backward-substitution calculation.

11. The method of any of claims 6 to 10, wherein step (d) comprises:

(d2) generating remaining parts of parity data by Gaussian elimination.

12. An apparatus for generating parity information based on a parity check matrix H having p codewords of length c,
each codeword being divided in a message word of length m and parity data of length p, the apparatus comprising:

(a) means (220) for reordering columns in the parity check matrix H, based on elements in each column having
values of 1 to generate a reordered parity check matrix H';
(b) means (230) for determining a cross-point I between a diagonal line L2 of a parity matrix part Mp in the parity
check matrix H' and a reordered diagonal line L1 defined by first entry of 1 in each column of the reordered
parity check matrix H', the diagonal line L2 representing a line that connects diagonal elements in the parity
matrix part Mp and, on the basis of positions of 1's in rows above a horizontal line L3 that passes through the
cross-point I to perform column permutations on the reordered parity check matrix H', for generating a triangular
matrix T; and
(c) means (250) for using the triangular matrix T and the message words to obtain the parity data;
(d) means (260) for using the equation Hx=0, where x is a codeword matrix, to obtain the rest of parity data
which is not obtained by (c).

13. The apparatus of claim 12, wherein the means (240) for reordering columns comprises:

means for finding 1's top position of each column in the parity check matrix H; and
means for reordering columns from left to right in the order of highest entry of 1 in each column.

14. The apparatus of claim 12 or 13, wherein the means (230) for determining a cross-point I and using positions of 1's
comprises:

means for sequentially exchanging from left to right columns of a message matrix part Mm with columns of the
parity matrix part Mp in the reordered parity check matrix H'.

15. The apparatus of claim 12 or 14, wherein the means (250) for using the triangular matrix T and the message words
generates parity data by the backward-substitution calculation using the triangular matrix T.

16. The apparatus of claim 15, wherein the means (230) for determining a cross-point I and for using positions of 1's generates the parity data by Gaussian elimination.

17. An apparatus for generating parity information based on a parity check matrix H having p codewords of length c, each codeword being divided in a message word of length m and parity data of length p, the apparatus comprising:

(a) means (220) for reordering columns in the parity check matrix H, based on elements in each column having values of 1 to generate a reordered parity check matrix H';
(b) means (230) for determining a cross-point I between a diagonal line L2 of a parity matrix part Mp in the parity check matrix H and a reordered diagonal line L1 defined by first entry of 1 in each column of the reordered parity check matrix H', the diagonal line L2 representing a line that connects diagonal elements in the parity matrix part Mp and, on the basis of positions of 1's in rows above a horizontal line L3 that passes through the cross-point I to perform column permutations on the reordered parity check matrix H', for generating a triangular matrix T; and
(c) means (240) for performing rows and columns permutation based on the positions of 1's in the rows to form an extended triangular matrix T, for rows under the horizontal line L3; and
(d) means (250) for using the extended triangular matrix T and the message words to generate the parity data.

18. The apparatus of claim 17, wherein the means (240) for performing rows and columns permutation comprises:

(c1) means for checking whether there is a row under the horizontal line L3, in which a second element from right to left having a value of 1 in the row is on the left of the diagonal line L2 of the parity matrix part Mp in the reordered parity check matrix H';
(c2) means for exchanging the row with a top-most row under the horizontal line L3, if there is the row in (c1); and
(c3) means for exchanging a first column having 1 in the new exchanged top-most row on the right of the diagonal line L2 with a second column having 1 in the same top-most row on the nearest left of the diagonal line L2.

19. The apparatus of claim 17 or 18, wherein the means (250) for using the extended triangular matrix T comprises:

(d1) means (250) for generating part of parity data by backward substitution calculation using the extended triangular matrix and the message words.

20. The apparatus of claim 17, 18 or 19, wherein the means for using the extended triangular matrix T comprises:

(d2) means (260) for generating remaining parity data by Gaussian elimination.

**Patentansprüche**

1. Verfahren zum Erzeugen von Paritätsdaten auf Basis einer Paritätsprüfungsmatrix H mit p Code-Worten der Länge c, wobei jedes Code-Wort in ein Nachrichten-Wort der Länge m und Paritätsdaten der Länge p unterteilt ist und das Verfahren umfasst:

a) Umordnen von Spalten der Paritätsprüfungsmatrix H auf Basis von Elementen in jeder Spalte, die Werte von 1 haben, um eine umgeordnete Paritätsprüfungsmatrix H' zu erzeugen;
b) Bestimmen eines Schnittpunktes I zwischen einer diagonalen Linie L2 eines Paritätsmatrixteils Mp in der Paritätsprüfungsmatrix H' und einer umgeordneten Diagonallinie L1, die durch den ersten Eintrag von 1 in jeder Spalte der umgeordneten Paritätsprüfungsmatrix H' definiert wird, wobei die diagonale Linie L2 eine Linie darstellt, die diagonale Elemente in dem Paritätsmatrixteil Mp verbindet, und auf Basis von Positionen von 1en in Reihen oberhalb einer horizontalen Linie L3, die durch den Schnittpunkt I hindurch verläuft, um Spalten-Permutationen an der umgeordneten Paritätsprüfungsmatrix H' durchzuführen, Erzeugen einer dreieckigen Matrix T;
c) Verwenden der dreieckigen Matrix T und der Nachrichten-Worte, um die Paritätsdaten zu ermitteln; und
d) Verwenden der Gleichung Hx=0, um den Rest der Paritätsdaten zu ermitteln, die in Schritt (c') nicht ermittelt werden, wobei x ein Code-Wort-Matrix ist.

2. Verfahren nach Anspruch 1, wobei Schritte (a) umfasst:

Suchen eines ersten Eintrags von 1 in jeder Spalte in der Paritätsprüfungsmatrix H; und

Umordnen der Spalten von links nach rechts in der Reihenfolge des höchsten Eintrags von 1 in jeder Spalte.

3. Verfahren nach Anspruch 1 oder 2, wobei Schritt (b) umfasst:

sequentielles Austauschen von Spalten eines Nachrichtenmatrixteils Mm gegen Spalten des Paritätsmatrixteils Mp in der umgeordneten Paritätsprüfungsmatrix H' von links nach rechts.

4. Verfahren nach Anspruch 1, 2 oder 3, wobei Schritt (c) durch ein Rückwärtssubstitutionsverfahren durchgeführt wird.

5. Verfahren nach Anspruch 1, 2, 3 oder 4, wobei Schritt (d) durch ein Gauß'sches Eliminationsverfahren durchgeführt wird.

6. Verfahren zum Erzeugen von Paritätsinformationen auf Basis einer Paritätsprüfungsmatrix H mit p Code-Worten der Länge c, wobei jedes Code-Wort in ein Nachrichten-Wort der Länge m und Paritätsdaten der Länge p unterteilt ist und das Verfahren umfasst:

a) Umordnen von Spalten in der Paritätsprüfungsmatrix H auf Basis von Elementen in jeder Spalte, die Werte von 1 haben, um eine umgeordnete Paritätsprüfungsmatrix H' zu ermitteln;
b) Bestimmen eines Schnittpunktes I zwischen einer diagonalen Linie L2 eines Paritätsmatrixteils Mp, der einem Paritätsprüfungsteil in der Paritätsprüfungsmatrix H' entspricht, und einer umgeordneten diagonalen Linie L1, die durch einen ersten Eintrag von 1 in jeder Spalte der umgeordneten Paritätsprüfungsmatrix H' definiert wird, wobei die diagonale Linie L2 eine Linie darstellt, die diagonale Elemente in dem Paritätsmatrixteil Mp verbindet, und auf Basis von Positionen von 1 en in Reihen oberhalb einer horizontalen Linie L3, die durch den Schnittpunkt 1 hindurch verläuft, um Spalten-Permutationen an der umgeordneten Paritätsprüfungsmatrix H' durchzuführen, Ausbilden einer dreieckigen Matrix T; und
c) für Reihen unter der horizontalen Linie L3 Durchführen von Reihen- und Spalten-Permutation auf Basis der Positionen von 1en in den Reihen, um ein erweiterte dreieckige Matrix T auszubilden; und
d) Verwenden der erweiterten dreieckigen Matrix T und der Nachrichten-Worte, um die Paritätsdaten zu ermitteln.

7. Verfahren nach Anspruch 6, wobei Schritt (c) umfasst:

c1) Prüfen, ob eine Reihe unter der horizontalen Linie L3 vorhanden ist, in der ein zweites Element von rechts nach links mit einem Wert von 1 in der Reihe links von der diagonalen Linie L2 des Paritätsmatrixteils Mp in der umgeordneten Paritätsprüfmatrix H' liegt;
c2) wenn in c1) die Reihe vorhanden ist, Austauschen der Reihe gegen die oberste Reihe unter der horizontalen Linie L3; und
c3) Austauschen einer ersten Spalte mit 1 in der neu ausgetauschten obersten Reihe rechts von der diagonalen Linie L2 gegen eine zweite Spalte mit 1 in der neu ausgetauschten obersten Reihe an der nächstgelegenen Position links von der diagonalen Linie L2.

8. Verfahren nach Anspruch 7, wobei die Schritte c1) bis c3) wiederholt durchgeführt werden, bis keine Reihe mehr vorhanden ist, in der ein zweites Element von rechts nach links mit einem Wert von 1 in der Reihe links von der diagonalen Linie L2 liegt.

9. Verfahren nach Anspruch 6, 7 oder 8, wobei Schritt d) umfasst:

d1) Erzeugen eines Teils von Paritätsdaten unter Verwendung der erweiterten dreieckigen Matrix und der Nachrichten-Worte.

10. Verfahren nach Anspruch 9, wobei Schritt d1) durch Rückwärtssubstitutions-Berechnung durchgeführt wird.

11. Verfahren nach einem der Ansprüche 6 bis 10, wobei Schritt d) umfasst:

d2) Erzeugen verbleibender Teile von Paritätsdaten durch Gauß'sche Elimination.

12. Vorrichtung zum Erzeugen von Paritätsinformationen auf Basis einer Paritätsprüfungsmatrix H mit p Code-Worten der Länge c, wobei jedes Code-Wort in ein Nachrichten-Wort der Länge m und Paritätsdaten der Länge p unterteilt ist und die Vorrichtung umfasst:

a) eine Einrichtung (220), die Spalten in der Paritätsprüfungsmatrix H auf Basis von Elementen in jeder Spalte, die Werte von 1 haben, umordnet, um eine umgeordnete Paritätsprüfungsmatrix H' zu erzeugen;

b) eine Einrichtung (230) die einen Schnittpunkt 1 zwischen einer diagonalen Linie L2 eines Paritätmatrixteils Mp in der Paritätsprüfungsmatrix H' und einer umgeordneten diagonalen Linie L1 bestimmt, die durch den ersten Eintrag von 1 in jeder Spalte der umgeordneten Paritätsprüfungsmatrix H' definiert wird, wobei die diagonale Linie L2 eine Linie darstellt, die diagonale Elemente in dem Paritätsmatrixteil Mp verbindet, und auf Basis von Positionen von 1en in Reihen oberhalb einer horizontalen Linie L3, die durch den Schnittpunkt I hindurch verläuft, um Spalten-Permutationen an der ungeordneten Paritätsprüfungsmatrix H' durchzuführen, eine dreieckige Matrix T erzeugt; und

c) eine Einrichtung (250), die die dreieckige Matrix T und die Nachrichten-Worte verwendet, um die Paritätsdaten zu ermitteln;

d) eine Einrichtung (260), die di Gleichung Hx=0 verwendet, um den Rest der Paritätsdaten zu ermitteln, die durch (c) nicht ermittelt werden, wobei x eine Code-Wort-Matrix ist.

**13.** Vorrichtung nach Anspruch 12, wobei die Einrichtung (240) zum Umordnen von Spalten umfasst:

eine Einrichtung, die die oberste 1-Position jeder Spalte in der Paritätsprüfungsmatrix H sucht; und
eine Einrichtung, die Spalten von links nach rechts in der Reihenfolge des höchsten Eintrags von 1 in jeder Spalte umordnet.

**14.** Vorrichtung nach Anspruch 12 oder 13, wobei die Einrichtung (230), die einen Schnittpunkt I bestimmt und Positionen von 1en verwendet, umfasst:

eine Einrichtung, die Spalten eines Nachrichtenmatrixteils Mm sequentiell von links nach rechts gegen Spalten des Paritätsmatrixteils Mp in der umgeordneten Paritätsprüfungsmatrix H' austauscht.

**15.** Vorrichtung nach Anspruch 12 oder 14, wobei die Einrichtung (250), die die dreieckige Matrix T und die Nachrichten-Worte verwendet, Paritätsdaten durch die Rückwärtssubstitutions-Berechnung unter Verwendung der dreieckigen Matrix T erzeugt.

**16.** Vorrichtung nach Anspruch 15, wobei die Einrichtung (230), die einen Schnittpunkt I bestimmt und Positionen von 1en verwendet, die Paritätsdaten durch Gauß'sche Elimination erzeugt.

**17.** Vorrichtung zum Erzeugen von Paritätsinformationen auf Basis einer Paritätsprüfungsmatrix H mit p Code-Worten der Länge c, wobei jedes Codewort in ein Nachrichten-Wort der Länge m und Paritätsdaten der Länge p unterteilt ist und die Vorrichtung umfasst:

a) eine Einrichtung (220), die Spalten in der Paritätsprüfungsmatrix H auf Basis von Elementen in jeder Spalte, die Werte von 1 haben, umordnet, um eine umgeordnete Qualitätsprüfungsmatrix H' zu erzeugen;

b) eine Einrichtung (230), die einen Schnittpunkt I zwischen einer diagonalen Linie L2 eines Paritätsmatrixteils Mp in der Paritätsprüfungsmatrix H und einer umgeordneten Diagonallinie L1 bestimmt, die durch den ersten Eintrag von 1 in jeder Spalte der umgeordneten Paritätsprüfungsmatrix H' definiert wird, wobei die diagonale Linie L2 eine Linie darstellt, die diagonale Elemente in dem Paritätsmatrixteil Mp verbindet, und auf Basis von Positionen von 1en in Reihen oberhalb einer horizontalen Linie L3, die durch den Schnittpunkt I verläuft, um Spalten-Permutationen an der ungeordneten Paritätsprüfungsmatrix H' durchzuführen, eine dreieckige Matrix T erzeugt; und

c) eine Einrichtung (240), die für Reihen unter der horizontalen Linie L3 Reihen- und Spalten-Permutation auf Basis der Positionen von 1 en in den Reihen durchführt, um eine erweiterte dreieckige Matrix T auszubilden; und

d) eine Einrichtung (250), die die erweiterte dreieckige Matrix T und die Nachrichten-Worte verwendet, um die Paritätsdaten zu erzeugen.

**18.** Vorrichtung nach Anspruch 17, wobei die Einrichtung (240) zum Durchführen von Reihen- und Spalten-Permutation umfasst:

c1) eine Einrichtung, die prüft, ob eine Reihe unter der horizontalen Linie L3 vorhanden ist, in der ein zweites Element von rechts nach links mit einem Wert von 1 in der Reihe links von der diagonalen Linie L2 des Paritätsmatrixteils Mp in der umgeordneten Paritätsprüfungsmatrix H' liegt;

c2) eine Einrichtung, die die Reihe gegen eine oberste Reihe unter der horizontalen Linie L3 austauscht, wenn in c1) die Reihe in vorhanden ist; und

c3) eine Einrichtung, die eine erste Spalte mit 1 in der neu ausgetauschten obersten Reihe rechts von der diagonalen Linie L2 gegen eine zweite Spalte mit 1 in der gleichen obersten Reihe an der nächstgelegenen Position links von der diagonalen Linie L2 austauscht.

**19.** Vorrichtung nach Anspruch 17 oder 18, wobei die Einrichtung (250), die die erweiterte dreieckige Matrix T verwendet, umfasst:

(d1) eine Einrichtung (250), die einen Teil von Paritätsdaten durch Rückwärtssubstitutions-Berechnung unter Verwendung der erweiterten dreieckigen Matrix und der Nachrichten-Worte erzeugt.

**20.** Vorrichtung nach Anspruch 17, 18 oder 19, wobei die Einrichtung, die die erweiterte dreieckige Matrix T verwendet, umfasst:

(d2) eine Einrichtung (260), die verbleibende Paritätsdaten durch Gauß'sche Elimination erzeugt.

## Revendications

**1.** Procédé pour générer des données de parité sur la base d'une matrice de contrôle de parité H ayant p mots de code de longueur c, chaque mot de code étant divisé en un mot de message de longueur m et des données de parité de longueur p, le procédé comportant les étapes consistant à :

(a) réordonner des colonnes de la matrice de contrôle de parité H sur la base d'éléments dans chaque colonne ayant des valeurs égales à 1 pour générer une matrice de contrôle de parité réordonnée H'
(b) déterminer un point d'intersection I entre une ligne diagonale L2 d'une partie Mp de la matrice de parité dans la matrice de contrôle de parité H' et une ligne diagonale réordonnée L1 définie par une première entrée égale à 1 dans chaque colonne de la matrice de contrôle de parité réordonnée H', la ligne diagonale L2 représentant une ligne qui relie des éléments de diagonale dans la partie Mp de la matrice de parité et, sur la base de positions des 1 dans des rangées au-dessus d'une ligne horizontale L3 qui passe par le point d'intersection I pour effectuer des permutations de colonnes sur la matrice de contrôle de parité réordonnée H', générer une matrice triangulaire T,
(c) utiliser la matrice triangulaire T et les mots de message pour obtenir les données de parité, et
(d) utiliser l'équation Hx=0, où x est une matrice de mots de code, pour obtenir le reste de données de parité qui n'est pas obtenu dans l'étape (c).

**2.** Procédé selon la revendication 1, dans lequel l'étape (1) comporte les étapes consistant à :

trouver une première entrée égale à 1 dans chaque colonne de la matrice de contrôle de parité H, et
réordonner les colonnes de la gauche vers la droite dans l'ordre de la plus haute entrée égale à 1 dans chaque colonne.

**3.** Procédé selon la revendication 1 ou 2, dans lequel l'étape (b) comporte l'étape consistant à :

échanger séquentiellement de la gauche vers la droite des colonnes d'une partie de matrice de messages Mm par des colonnes de la partie Mp de la matrice de parité dans la matrice de contrôle de parité réordonnée H'.

**4.** Procédé selon la revendication 1, 2 ou 3, dans lequel l'étape (c) est effectuée par un procédé de substitution en arrière.

**5.** Procédé selon la revendication 1, 2, 3 ou 4, dans lequel l'étape (d) est effectuée par un procédé d'élimination Gaussienne.

**6.** Procédé pour générer des informations de parité sur la base d'une matrice de contrôle de parité H ayant p mots de code de longueur c, chaque mot de code étant divisé en un mot de message de longueur m et des données de parité de longueur p, le procédé comportant les étapes consistant à :

(a) réordonner des colonnes de la matrice de contrôle de parité H sur la base d'éléments dans chaque colonne ayant des valeurs égales à 1 pour obtenir une matrice de contrôle de parité réordonnée H',

(b) déterminer un point d'intersection I entre une ligne diagonale L2 d'une partie Mp de la matrice de parité qui correspond à une partie d'informations de parité dans la matrice de contrôle de parité H' et une ligne diagonale réordonnée L1 définie par la première entrée égale à 1 dans chaque colonne de la matrice de contrôle de parité réordonnée H', la ligne diagonale L2 représentant une ligne qui relie des éléments de diagonale dans la partie Mp de la matrice de parité et, sur la base de positions des 1 dans des rangées au-dessus d'une ligne horizontale L3 qui passe par le point d'intersection I pour effectuer des permutations de colonnes sur la matrice de contrôle de parité réordonnée H', former une matrice triangulaire T, et

(c) pour des rangées sous la ligne horizontale L3, effectuer une permutation de rangées et de colonnes sur la base des positions des 1 dans les rangées pour former une matrice triangulaire étendue T, et

(d) utiliser la matrice triangulaire étendue T et les mots de message pour obtenir les données de parité.

7. Procédé selon la revendication 6, dans lequel l'étape (c) comporte les étapes consistant à :

(c1) vérifier s'il y a une rangée sous la ligne horizontale L3, dans laquelle un second élément à partir de la droite vers la gauche ayant une valeur de 1 dans la rangée se trouve à gauche de la ligne diagonale L2 de la partie Mp de matrice de parité dans la matrice de contrôle de parité réordonnée H',

(c2) si la rangée existe dans (c1), échanger la rangée avec une rangée la plus haute sous la ligne horizontale L3, et

(c3) échanger une première colonne ayant 1 dans la nouvelle rangée la plus haute échangée à droite de la ligne diagonale L2 avec une seconde colonne ayant un 1 dans la nouvelle rangée la plus haute échangée sur la gauche le plus près de la ligne diagonale L2.

8. Procédé selon la revendication 7, dans lequel les étapes (c1) à (c3) sont effectuées d'une manière répétée jusqu'à ce qu'il n'existe plus de rangées, dans lequel un second élément de la droite vers la gauche ayant une valeur égale à 1 dans la rangée se trouve à gauche de la ligne diagonale L2.

9. Procédé selon la revendication 6, 7 ou 8, dans lequel l'étape (d) comporte l'étape consistant à :

(d1) générer une partie de données de parité en utilisant la matrice triangulaire étendue et les mots de message.

10. Procédé selon la revendication 9, dans lequel l'étape (d1) est effectuée par un calcul de substitution en arrière.

11. Procédé selon l'une quelconque des revendications 6 à 10, dans lequel l'étape (d) comporte l'étape consistant à :

(d2) générer des parties restantes de données de parité par élimination Gaussienne.

12. Dispositif pour générer des informations de parité sur la base d'une matrice de contrôle de parité H ayant p mots de code de longueur c, chaque mot de code étant divisé en un mot de message de longueur m et données de parité de longueur p, le dispositif comportant :

(a) des moyens (220) pour réordonner des colonnes de la matrice de contrôle de parité H, sur la base d'éléments dans chaque colonne ayant des valeurs égales à 1 pour générer une matrice de contrôle de parité réordonnée H',

(b) des moyens (230) pour déterminer un point d'intersection I entre une ligne diagonale L2 d'une partie Mp de la matrice de parité dans la matrice de contrôle de parité H' et une ligne diagonale réordonnée L1 définie par la première entrée égale à 1 dans chaque colonne de la matrice de contrôle de parité réordonnée H', la ligne diagonale L2 représentant une ligne qui relie des éléments de diagonale dans la partie Mp de la matrice de parité et, sur la base de positions des 1 dans des rangées au-dessus d'une ligne horizontale L3 qui passe par le point d'intersection I pour effectuer des permutations de colonnes sur la matrice de contrôle de parité réordonnée H', pour générer une matrice triangulaire T,

(c) des moyens (250) pour utiliser la matrice triangulaire T et les mots de message pour obtenir les données de parité, et

(d) des moyens (260) pour utiliser l'équation Hx=0, où x est une matrice de mots de code, pour obtenir le reste de données de parité qui n'est pas obtenu par (c).

13. Dispositif selon la revendication 12, dans lequel les moyens (240) destinés à réordonner les colonnes comportent :

des moyens pour trouver la position en haut des 1 de chaque colonne dans la matrice de contrôle de parité H, et des moyens pour réordonner des colonnes de gauche à droite dans l'ordre de la plus haute entrée des 1 dans chaque colonne.

**14.** Dispositif selon la revendication 12 ou 13, dans lequel les moyens (230) destinés à déterminer un point d'intersection I et utiliser les positions des 1 comportent :

des moyens pour séquentiellement échanger de la gauche vers la droite des colonnes d'une partie de matrice de messages Mm par des colonnes de la partie Mp de la matrice de parité dans la matrice de contrôle de parité réordonnée H'.

**15.** Dispositif selon la revendication 12 ou 14, dans lequel les moyens (250) destinés à utiliser la matrice triangulaire T et les mots de message génèrent des données de parité par le calcul de substitution en arrière en utilisant la matrice triangulaire T.

**16.** Dispositif selon la revendication 15, dans lequel les moyens (230) pour déterminer un point d'intersection I et pour utiliser les positions des 1 génèrent les données de parité par élimination Gaussienne.

**17.** Dispositif pour générer des informations de parité sur la base d'une matrice de contrôle de parité H ayant p mots de code de longueur c, chaque mot de code étant divisé en un mot de message de longueur m et données de parité de longueur p, le dispositif comportant :

(a) des moyens (220) pour réordonner les colonnes dans la matrice de contrôle de parité H, sur la base d'éléments dans chaque colonne ayant des valeurs égales à 1 pour générer une matrice de contrôle de parité réordonnée H',
(b) des moyens (230) pour déterminer un point d'intersection I entre une ligne diagonale L2 d'une partie Mp de la matrice de parité dans la matrice de contrôle de parité H' et une ligne diagonale réordonnée L1 définie par la première entrée égale à 1 dans chaque colonne de la matrice de contrôle de parité réordonnée H', la ligne diagonale L2 représentant une ligne qui relie des éléments de diagonale dans la partie Mp de la matrice de parité et, sur la base des positions des 1 dans des rangées au-dessus d'une ligne horizontale L3 qui passe par le point d'intersection I pour effectuer des permutations de colonnes sur la matrice de contrôle de parité réordonnée H', pour générer une matrice triangulaire T, et
(c) des moyens (240) pour effectuer une permutation de rangées et de colonnes sur la base des positions des 1 dans les rangées pour former une matrice triangulaire étendue T, pour des rangées sous la ligne horizontale L3, et
(c) des moyens (250) pour utiliser la matrice triangulaire étendue T et les mots de message pour générer les données de parité.

**18.** Dispositif selon la revendication 17, dans lequel les moyens (240) pour effectuer une permutation de rangées et de colonnes comportent :

(c1) des moyens pour vérifier s'il y a une rangée sous la ligne horizontale L3, dans laquelle un second élément de la droite vers la gauche ayant une valeur de 1 dans la rangée se trouve à gauche de la ligne diagonale L2 de la partie Mp de la matrice de parité dans la matrice de contrôle de parité réordonnée H',
(c2) des moyens pour échanger la rangée avec une rangée la plus haute sous la ligne horizontale L3, si la rangée existe dans (c1), et
(c3) des moyens pour échanger une première colonne ayant un 1 dans la nouvelle rangée la plus haute échangée à droite de la ligne diagonale L2 avec une seconde colonne ayant un 1 dans la même rangée la plus haute à gauche le plus près de la ligne diagonale L2.

**19.** Dispositif selon la revendication 17 ou 18, dans lequel les moyens (250) destinés à utiliser la matrice triangulaire étendue T comportent :

(d1) des moyens (250) pour générer une partie de données de parité par un calcul de substitution en arrière en utilisant la matrice triangulaire étendue et les mots de message.

**20.** Dispositif selon la revendication 17, 18 ou 19, dans lequel les moyens destinés à utiliser la matrice triangulaire étendue T comportent :

(d2) des moyens (260) pour générer des données de parité restantes par élimination Gaussienne.

# FIG. 1

## FIG. 2

MESSAGE BIT

| 210 | 220 | 230 | 240 | 250 |
|---|---|---|---|---|
| PARITY CHECK MATRIX GENERATION UNIT | COLUMN PERMUTATION UNIT | TRIANGULAR MATRIX GENERATION UNIT | TRIANGULAR MATRIX EXTENSION UNIT | BACKWARD SUBSTITUTION CALCULATOR |

260

LOWER PART PARITY CALCULATOR

PARITY BIT

EP 1 443 656 B1

## FIG. 3A

## FIG. 3B

# FIG. 3C

# FIG. 4A

# FIG. 4B

# FIG. 4C

Cp    Cq

| 1 | 0 | 0 | 0 | 1 | 0 | 0 | 0 |  ) R3

1

| 0 | 1 | 1 | 0 | 0 | 0 | 0 | 0 |  ) R1

L1

L2

EXCHANGE

# FIG. 4D

EXTENSION PART   UN—DIAGONALIZED PART

L2

| 1 | 1 | 0. | 0 | 0 | 0 | 0 | 0 |  ) R3

1

| 0 | 0 | 1 | 0 | 1 | 0 | 0 | 0 |  ) R1

Cq    Cp

## FIG. 5

```
( START )
    │
    ▼
┌─────────────────────────────────────────────┐
│ GENERATE PARITY CHECK MATRIX H              │── 501
└─────────────────────────────────────────────┘
    │
    ▼
┌─────────────────────────────────────────────┐
│ REORDER COLUMNS OF PARITY CHECK MATRIX      │── 502
│ H TO FORM REORDERED CHECK MATRIX H'         │
└─────────────────────────────────────────────┘
    │
    ▼
┌─────────────────────────────────────────────┐
│ DETERMINE CROSS-POINT I BETWEEN DIAGONAL    │
│ LINE L1 OF REORDERED CHECK MATRIX H'        │── 503
│ AND DIAGONAL LINE L2 OF PARITY PART MATRIX  │
└─────────────────────────────────────────────┘
    │
    ▼
┌─────────────────────────────────────────────┐
│ GENERATE TRIANGULAR MATRIX T BY EXCHANGING  │
│ COLUMNS OF REORDERED PARITY CHECK MATRIX    │── 504
│ H', IN ACCORDANCE WITH POSITIONS OF 1'S OF  │
│ ALL THE ROWS ABOVE HORIZONTAL LINE L3       │
└─────────────────────────────────────────────┘
    │
    ▼
```

IS THERE
A ROW IN WHICH SECOND ELEMENT
FROM RIGHT TO LEFT HAVING A VALUE OF — 505
1 IN THE ROW IS ON THE LEFT OF
HORIZONTAL LINE L3?

NO         YES

```
┌──────────────────┐
│ REGENERATE PARITY│── 509
│ CHECK MATRIX THAT│
│ INCLUDES NEW     │
│ TRIANGULAR MATRIX│
└──────────────────┘
    │
    ▼
┌──────────────────┐
│ GENERATE PART OF │── 510
│ PARITY DATA BY   │
│ BACKWARD-        │
│ SUBSTITUTION     │
│ CALCULATION, AND │
│ GENERATE REMAINING│
│ PARTS OF PARITY  │
│ DATA BY GAUSSIAN │
│ ELIMINATION      │
└──────────────────┘
    │
    ▼
 ( END )
```

```
┌─────────────────────────────────────────────┐
│ EXTRACT A ROW IN WHICH SECOND ELEMENT       │
│ FROM RIGHT TO LEFT HAVING A VALUE OF 1 THE  │
│ LEFT OF HORIZONTAL LINE L3, AND EXCHANGE    │── 506
│ THE EXTRACTED ROW WITH TOP-MOST ROW         │
│ UNDER HORIZONTAL LINE L3                     │
└─────────────────────────────────────────────┘
    │
    ▼
┌─────────────────────────────────────────────┐
│ EXCHANGE A COLUMN Cq HAVING '1' IN          │
│ EXTRACTED ROW ON THE RIGHT DIAGONAL         │
│ LINE L2 WITH A COLUMN Cp HAVING '1'         │── 507
│ IN THE SAME EXTRACTED ROW                    │
│ ON THE LEFT OF DIAGONAL LINE L2             │
└─────────────────────────────────────────────┘
    │
    ▼
┌─────────────────────────────────────────────┐
│ REPEATEDLY PERFORM ROW AND COLUMN           │── 508
│ EXCHANGE OF STEPS 506 TO 507                 │
└─────────────────────────────────────────────┘
```